# EUROPEAN PATENT APPLICATION

(11) **EP 3 792 967 A1**
(43) Date of publication of application: **17.03.2021**
(21) Application number: 19197468.2
(22) Date of filing: 16.09.2019
(51) Int. Cl.: H01L 23/433, H01L 23/473, H01L 23/373

(54) **HEAT SINK**

(71) Applicant: Nokia Technologies Oy, 02610 Espoo (FI)
(72) Inventor: JEFFERS, Nicholas, Wicklow, A63YH63 (IE)
(74) Representative: Nokia EPO representatives

(57) **Abstract**

An apparatus is disclosed, which may comprise a heat sink apparatus. The apparatus may comprising means, or a first part, for transferring thermal energy received from a component to a fluid medium. The apparatus may also comprise means, or a part, for deforming due to applied pressure when contacting the component. The thermal energy transferring means, or part, and the deforming means, or part, may be integrally formed.

## Description

### Field

Example embodiments relate to a heat sink and also to a method for manufacturing a heat sink.

### Background

A heat sink is an apparatus used to transfer heat generated by an electronic or mechanical device to, usually, a fluid medium. It is known that electronic devices, such as integrated circuits (ICs), generate heat when operating and that damage may occur to the IC if it is allowed to overheat. Therefore, it is usual to place a heat sink, usually formed of metal close to the IC so that the heat is dissipated away from the IC, for example to the surrounding air. A heat sink may be designed to maximize its surface area in contact with the air, and for this reason may be appropriately shaped with multiple fins or blades on an outer surface.

### Summary

The scope of protection sought for various embodiments of the invention is set out by the independent claims. The embodiments and features, if any, described in the specification that do not fall under the scope of the independent claims are to be interpreted as examples useful for understanding various embodiments of the invention.

According to one aspect, there is provided an apparatus, comprising: means for transferring thermal energy received from a component to a fluid medium; and means for deforming due to applied pressure when contacting the component, wherein the thermal energy transferring means and the deforming means are integrally formed.

The thermal energy transferring means and the deforming means may be integrally formed by additive or subtractive manufacturing using a common material.

The common material may be a metal material. For example, the metal material may be one of aluminum, an alloy of aluminum, copper, stainless steel, titanium, cobalt, chrome and Inconel.

The thermal energy transferring means may be configured as a three-dimensional lattice structure comprising a substantially repeating arrangement of struts and nodes arranged in such a way as to resist deformation due to applied pressure.

The deforming means may comprise a plurality of struts that each extend generally away, and at an oblique angle from, a node of the thermal energy transferring means and which undergo rotational movement due to applied pressure when contacting the component.

The deforming means may comprise one or more foot members carried by two or more struts, which foot members is or are configured to move to a substantially flattened configuration against the component due to the applied pressure when contacting the component.

The deforming means may be configured to undergo plastic deformation when deformed.

The thermal energy transferring means may be divided into a plurality of sections having respective heights corresponding to different heights of a plurality of components, at least one section having a separate deforming means for respectively contacting said plurality of components.

The apparatus may further comprise means for sealing a container, the sealing means comprising a lid-like member integrally formed with the thermal energy transferring means of the apparatus, which lid-like member is configured to close a chamber for containing one or more components.

The apparatus may further comprise means for containing a fluid, the containing means being integrally formed with, and containing at least part of, the thermal energy transferring means, and the deforming means being at least partly external to the containing means.

The containing means may further comprise a first aperture for receiving a liquid and a second aperture for the liquid to exit in use.

According to another aspect, there may be provided a method of manufacture of an apparatus, the apparatus comprising means for transferring thermal energy received from a component to a fluid medium, and means for deforming due to applied pressure when contacting the component, wherein the thermal energy transferring means and the deforming means are integrally formed, the method comprising integrally forming the thermal energy transferring means and the deforming means by additive or subtractive manufacturing using a common material.

The thermal energy transferring means may be formed as a three-dimensional lattice structure comprising a substantially repeating arrangement of struts and nodes arranged in such a way as to resist deformation due to applied pressure.

The deforming means may be formed by a plurality of struts that each extend generally away, and at an oblique angle from, a node of the thermal energy transferring means and which undergo rotational movement due to applied pressure when contacting the component.

According to another aspect, there may be provided an apparatus, comprising a heat sink integrally formed of first and second parts, the first part arranged to transfer thermal energy received from a component to a fluid medium and the second part arranged to deform due to applied pressure when contacting the component. The two parts may be integrally formed by additive or subtractive manufacture. Preferred features defined herein are applicable to the first and second parts.

According to another aspect, there may be provided a system comprising at least one component on a printed circuit board and a heat sink integrally formed of first and second parts, the first part arranged to transfer thermal energy received from a component to a fluid medium and the second part arranged to deform due to applied pressure when contacting the component. The two parts may be integrally formed by additive or subtractive manufacture. Preferred features defined herein are applicable to the first and second parts.

### Brief Description of the Drawings

Example embodiments will be described by way of non-limiting example, with reference to the accompanying drawings, in which:
FIGS. 1A and 1B show in schematic form a heat sink apparatus according to an example embodiment in respective first and second configurations;
FIGS. 2A and 2B respectively show a heat sink apparatus in perspective and partial underside views according to an example embodiment;
FIGS. 3A and 3B are partial side-sectional views of the FIG. 2A heat sink apparatus in respective first and second configurations;
FIG. 3C is a schematic view of part of the FIG. 3B heat sink apparatus, indicating deformation of the part due to applied pressure in the second configuration;
FIGS. 4A and 4B respectively show partial side-sectional views of a heat sink apparatus according to another example embodiment in respective first and second configurations;
FIGS. 5A and 5B respectively show partial side-sectional views of a heat sink apparatus according to another example embodiment in respective first and second configurations;
FIGS. 6A and 6B respectively show partial side-sectional views of a heat sink apparatus according to another example embodiment in respective first and second configurations;
FIG. 7 is a flow diagram showing operations in forming a heat sink apparatus according to an example embodiment; and
FIG. 8 is another flow diagram showing operations in forming a heat sink apparatus according to an example embodiment;

### Detailed Description

Example embodiments relate to heat sinks and also to a method for manufacturing a heat sink. As mentioned, a heat sink is an apparatus used to transfer heat generated by an electronic or mechanical device to, usually, a fluid medium. In examples described herein, heat sinks for transferring heat from one or more electrical or electronic components will be described. Such components may comprise microprocessors, power supplies, integrated circuits and so on. It should however be appreciated that heat sinks according to example embodiments, and their method of manufacture, may be applied also to other components, including mechanical components.

Example embodiments provide a heat sink apparatus that, in use, improves thermal contact between the heat sink itself and the component that it is used to cool, i.e. move thermal energy away from. In this respect, any interface between separate components represents a source of thermal resistance. Hence, example embodiments provide heat sinks that remove this thermal resistance by integrating an interface, sometimes called thermal interface material (TIM), to the heat sink itself. Typically, TIMs are separate elements that sit between the component and the heat sink. By integrating the TIM and the heat sink, e.g. through additive or subtractive manufacturing techniques such as three-dimensional printing, this source of thermal resistance is removed because of the unitary structure. Effectively, the heat sink comprises both a part for transferring thermal energy away from a component to a fluid medium such as air, and also an interface part for contact with the component in use, both being integrally formed with one another.

Example embodiments also provide an interface that deforms when pressure is applied as the heat sink makes contact with the component to be cooled. The interface may provide a form of deformable, collapsible or crumple zone, to improve or maximize surface contact of the interface with the component by increasing the surface area that is in direct contact. The deformation may be plastic deformation, i.e. that which does not return to its original state when the pressure is released. Deformation also permits the interface to substantially conform to complex component shapes, or arrangements of multiple components which may have different profiles or heights.

The heat sink may be formed of any suitable material with appropriate thermally-conductive properties. The material of the thermal energy transferring part and that of the interface part may be a common material such as a metal. For example, aluminium or an alloy of aluminium may be used. Other materials that may be used include copper, stainless steel, titanium, cobalt, chrome and Inconel. It is known to deposit such materials through additive manufacturing techniques akin to three-dimensional printing and / or through selective laser sintering (SLS).

In preferred embodiments, the heat sink is manufactured as a three-dimensional lattice. A lattice may take various forms but is generally defined as a structure comprising an arrangement of struts in substantially repeating patterns with nodes at the intersections between different struts. A strut can be any longitudinal arm or beam. In the three-dimensional sense, the arrangement of struts may define a grid or array of cells, a cell being the space between the struts. A box-like cell may be defined by twelve struts and eight nodes. Cells may be box-like, diamond-like, hexagonal-like or indeed of any suitable form depending on the relative angles between differently-oriented struts. Lattices may be easily formed by additive or subtractive manufacturing techniques and also offer significant benefits, including strength (high strength to weight ratio) and high surface area.

The thermal energy transferring part may therefore be formed as a three-dimensional lattice to provide a robust structure that can dissipate thermal energy efficiently. The interface part may also comprise a three-dimensional lattice, but one which may be configured differently to permit its deformation, at least at a distal end, and to permit it to maximize surface contact with the heat-generating component. This interface part may comprise an incomplete lattice at the distal end, i.e. one having struts not connected to nodes which continue the lattice structure.

For ease of explanation, the thermal energy transferring part will hereafter be referred to as the "heat transfer part".

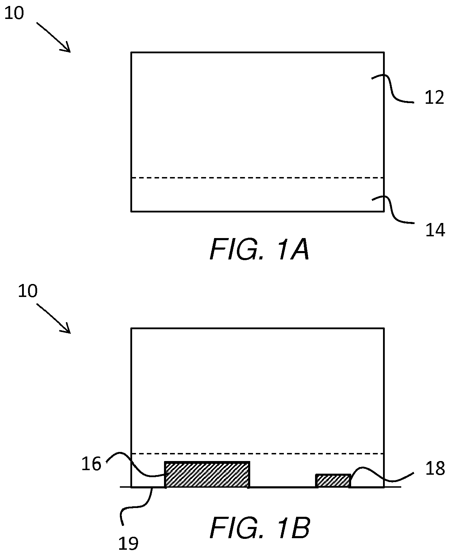

FIGS. 1A and 1B show in schematic form a heat sink 10, according to an example embodiment. The heat sink 10 comprises first and second sections, the first section being the heat transfer part 12 and the second section being the interface part 14. The interface part 14 for this embodiment is below, or distal to, the heat transfer part 12 and may be thinner, but this is not necessarily the case. Referring specifically to FIG. 1B, the heat sink 10 is shown when its distal end makes contact with first and second electronic components 16, 18 on a printed circuit board (PCB) 19. The interface part 14 deforms so as to substantially conform to the outer surface of each component 16, 18 so as to increase or maximise surface contact between the interface part and the components. Any gaps, even microscopic ones, should be minimized. The microstructure of the interface part 14 that results from deformation will be discussed in more detail below.

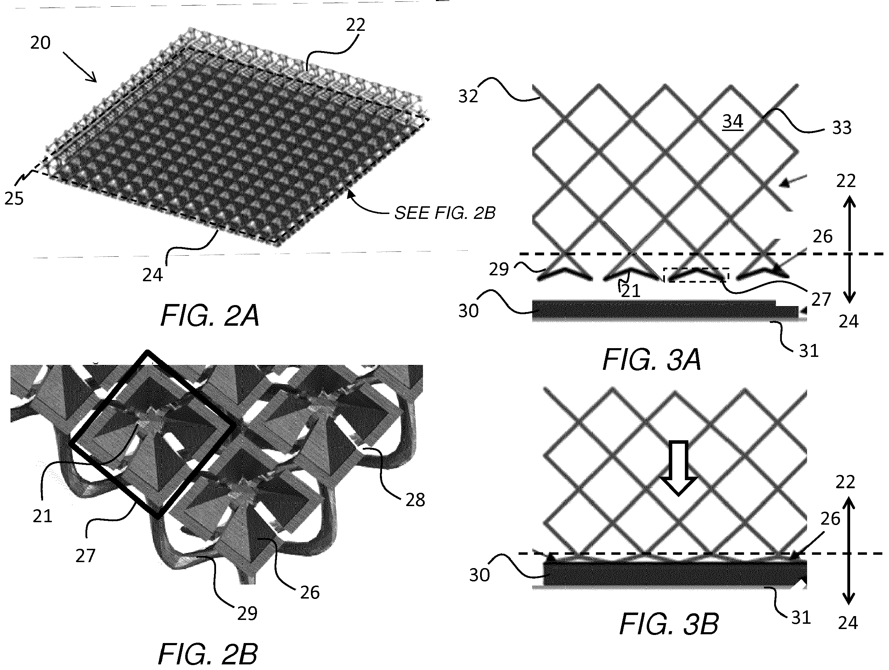

FIG. 2A is a perspective view of a heat sink 20, according to an example embodiment. The heat sink 20 comprises an integral three-dimensional lattice structure, comprising an aforementioned heat transfer part 22 comprising cells defined by interconnected spars and an interface part 24, the two parts being delimited by a two-dimensional plane indicated by the broken line 25.

FIG. 2B is a close-up version of the underside of the interface part 24, which shows in greater detail an example structure of said interface part that deforms in use. The distal end of the interface part 24 comprises a plurality of three-dimensional pads 26 which, in a non-deformed state, extend upwardly towards to the heat transfer part 22. In the shown example, four such pads 26 are grouped such that they collectively provide a foot 27. For example, each pad 26 is a corner section of a square or rectangular -shaped foot 27, with air gaps 28 between adjacent inner edges of each pad to permit deformation under applied pressure. The pads 26 may meet at an apex 21.

Supporting each or some of the pads 26 is or are one or more spars 29 of the lattice structure which may remain rigid or may also deform outwardly under applied pressure. Other shapes or arrangements of pads 26 and feet 27 may be used. Different numbers of pads 26 and feet 27 may be used.

FIGS. 3A and 3B are schematic side-sectional views of the heat sink 20 when respectively free-standing and under applied pressure against a component 30 that may be mounted on a PCB 31.

Referring to FIG. 3A, it will be seen that the heat transfer part 22 is formed of a plurality of spars 32, arranged oblique (i.e. not parallel or orthogonal) to a vertical axis, which interconnect with other spars arranged at a different oblique orientations at interconnecting nodes 33. A group of interconnecting spars 32 define a cell 34 which does not substantially deform under applied pressure (relative to deformation of the interface part 24) due to the inherent strength of the resulting lattice structure. The vertical axis is usually, but not necessarily, parallel to the direction of applied pressure onto a component which may be orthogonal to said axis.

It will also be seen that the interface part 24 comprises spars 29, each of which may be an extension of at least some of the aforementioned spars 32, but which do not continue the lattice structure in the sense that they do not interconnect with other spars at nodes. The spars 29 likewise are at an oblique angle to the vertical axis. At or close to said ends are provided the above-mentioned pads 26. As will be seen, each pad 26 extends upwards at an oblique angle towards the apex 21.

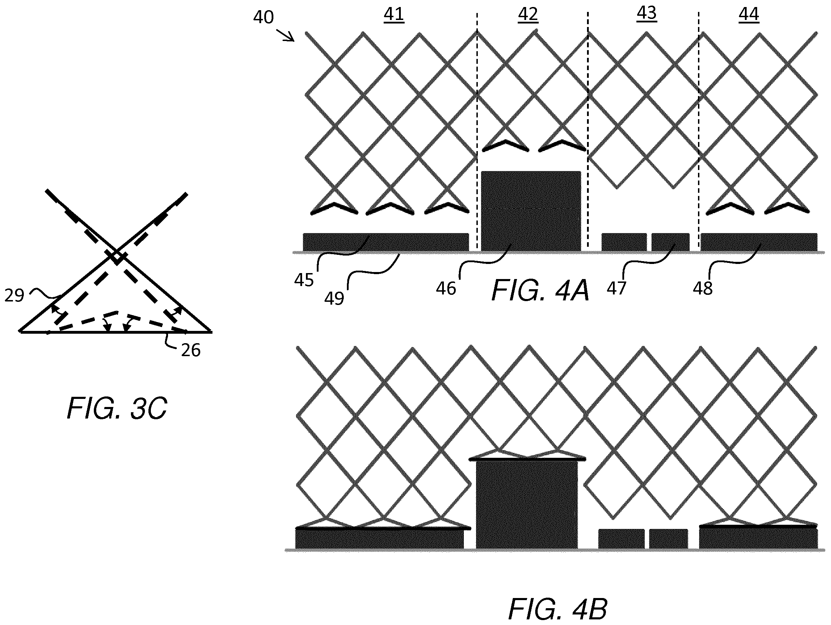

Referring to FIG. 3B, and as shown more closely in FIG. 3C, when pressure is applied to locate the heat sink 20 in contact with the component 30, the spars 29 of the interface part 29 are urged outwardly apart as rotational movement. This causes the opposed pads 26, joined at one part to a spar and at another part to the apex 21, to rotate in the opposite orientation until the apex contacts the component 30. At this time, the pads 26 are parallel with the surface of the component, assuming the pads and the component's upper surface are planar, and hence surface contact is maximized.

It will be appreciated that the lattice arrangement shown and described with reference to FIGS. 2 and 3 is merely an example, and alternative arrangements which provide, due to applied pressure, a collapsing or crumpling of an integral interface part to enhance surface contact with the underlying component are within the scope of this disclosure. For example, different oblique angles of the lattice spars may be employed, and these may define different-shaped cells, other than diamonds.

Referring to FIGS. 4A and 4B, another heat sink 40 according to an example embodiment is shown. Similar to the heat sink 30 described with reference to FIG. 30, the heat sink 40 comprises a heat transfer part formed of a plurality of spars, arranged oblique (i.e. not parallel or orthogonal) to a vertical axis, which interconnect with other spars arranged at a different oblique orientations at interconnecting nodes. The interface part also comprises spars, each of which may be an extension of at least some of the aforementioned spars, but which do not continue the lattice structure in the sense that they do not interconnect with other spars at nodes. The spars likewise are at an oblique angle to the vertical axis. At or close to said ends are provided the above-mentioned pads, with each pad 26 extending upwards at an oblique angle towards the apex. In this case, the interface part is divided into a plurality of sections 41 - 44, each having a different vertical extent in correspondence to the vertical extent (height) of respective components 45 - 48 on an underlying PCB 49. One set 47 of said components do not require heat dissipation and hence no pads are provided at the distal end of the interface part. Otherwise, each section 41, 42, 44 works in the same way as FIGS. 3A - 3C, with each said section making contact and deforming at substantially the same time, notwithstanding the different dimensions and heights of the components 45, 46, 48. The heat sink 40 may be formed using the same integral structure as described above.

The heat sink 40 may therefore cool multiple components, avoiding the need to provide a PCB or base, machined or otherwise provided with raised sections and/or cavities to vertically align the components. This saves weight, cost and decreases the thermal resistance as previously mentioned, as well as increasing the area / volume of the cooling surface area.

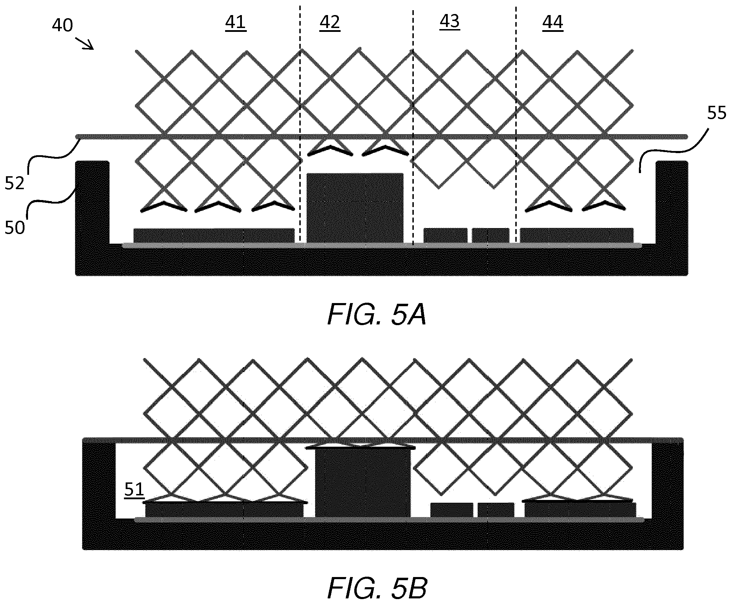

Referring to FIGS. 5A and 5B, the FIG. 4A and 4B embodiment of the heat sink 40 may be adapted for use in hermetically-sealed units. The unit may comprise a base 50 for housing the PCB 49 and components in an interior chamber 51, and a lid 52. Rather than channelling heat from the bottom of such a unit, as is often the case, the example embodiment permits integrating or otherwise linking the heat sink 40 to the lid 52 as shown. The lid 52 incorporating the heat sink 40 as shown may be provided as a one-piece three-dimensional structure through additive manufacturing. It is generally difficult to achieve heat-sink functionality through a lid because of tolerances, but through use of example embodiments, it is more easily achieved. Deformation or crumpling of the interface part 55 allows greater flexibility to achieve the required tolerances. Upon placement of the lid 52 onto the upper surface of the base 50, the interface part 55 is deformed and in contact with the underlying components and the lid can be sealed as required.

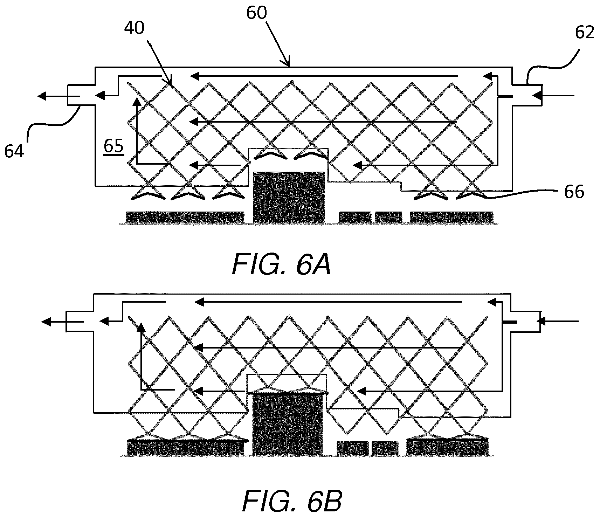

Referring to FIGS. 6A and 6B, the FIG. the FIG. 4A and 4B embodiment of the heat sink 40 may be adapted for use in a liquid or two-phase cold plate unit 60. The unit 60 may comprise a chamber 65 through which flows a fluid, such as a coolant liquid, which enters through an inlet 62 and exits through an outlet 64 as shown by means of a pump (not shown). The liquid may move through and around the heat sink 40 such that thermal energy within the energy transfer part (housed within the chamber 65) transfers to the surrounding liquid and exits through the outlet 64, enabling a more rapid cooling. The interface part 66 may be outside of the chamber 65 as shown, and may contact the components as described above when in the FIG. 5B collapsed configuration. The cold plate unit 60 incorporating the heat sink 40 as shown may be provided as a one-piece three-dimensional structure through additive manufacturing.

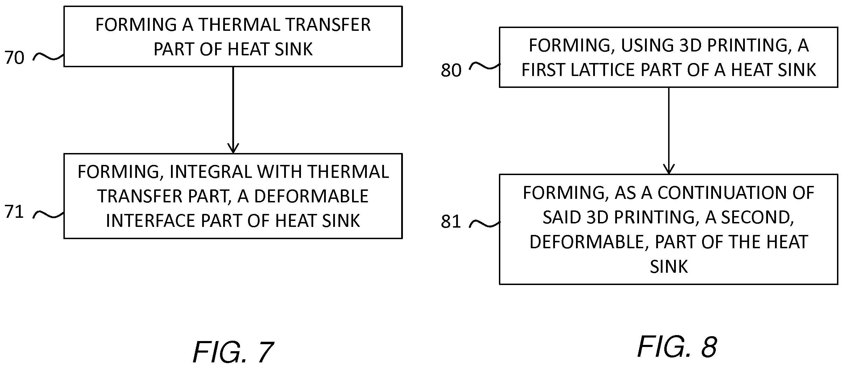

FIG. 7 is a flow diagram showing example operations that may comprise a manufacturing method for producing a heat sink according to example embodiments.

A first operation 70 may comprise forming a thermal transfer part of a heat sink.

A second operation 71 may comprise forming, integral with the thermal transfer part, a deformable interface part of the heat sink.

The first and second operations 70, 71 may be reversed in order. Other operations may also be added. The thermal transfer and interface parts may be formed in sequence using, for example, three-dimensional printing. The parts may be formed of a common material, such as a metal material. Aluminium or an alloy of aluminium, e.g. AlSi10, may be used. Any other high-conductivity metal or material may be used, if usable in a three-dimensional printing process.

FIG. 8 is a flow diagram showing example operations that may comprise a manufacturing method for producing a heat sink according to another example embodiment.

A first operation 80 may comprise forming, using three-dimensional printing, a first lattice part of a heat sink.

A second operation 81 may comprise forming, as a continuation of said three-dimensional printing process, a deformable part of the heat sink.

The first and second operations 80, 81 may be reversed in order. Other operations may also be added. The two parts may be formed in sequence using. The parts may be formed of a common material, such as a metal material. Aluminium or an alloy of aluminium, e.g. AlSi10, may be used. Any other high-conductivity metal or material may be used, if usable in a three-dimensional printing process.

While the forgoing examples are illustrative of the principles of the present invention in one or more particular applications, it will be apparent to those of ordinary skill in the art that numerous modifications in form, usage and details of implementation can be made without the exercise of inventive faculty, and without departing from the principles and concepts of the invention. Accordingly, it is not intended that the invention be limited, except as by the claims set forth below.

## Claims

1. Apparatus, comprising:
means for transferring thermal energy received from a component to a fluid medium; and
means for deforming due to applied pressure when contacting the component,
wherein the thermal energy transferring means and the deforming means are integrally formed.

2. The apparatus of claim 1, wherein the thermal energy transferring means and the deforming means are integrally formed by additive or subtractive manufacturing using a common material.

3. The apparatus of claim 2, wherein the common material is a metal material.

4. The apparatus of claim 3, wherein the metal material is one of aluminum or an alloy of aluminum.

5. The apparatus of any preceding claim, wherein the thermal energy transferring means is configured as a three-dimensional lattice structure comprising a substantially repeating arrangement of struts and nodes arranged in such a way as to resist deformation due to applied pressure.

6. The apparatus of any preceding claim, wherein the deforming means comprises a plurality of struts that each extend generally away, and at an oblique angle from, a node of the thermal energy transferring means and which undergo rotational movement due to applied pressure when contacting the component.

7. The apparatus of claim 5 or claim 6, wherein the deforming means comprises one or more foot members carried by two or more struts, which foot members is or are configured to move to a substantially flattened configuration against the component due to the applied pressure when contacting the component.

8. The apparatus of any preceding claim, wherein the deforming means is configured to undergo plastic deformation when deformed.

9. The apparatus of any preceding claim, wherein the thermal energy transferring means is divided into a plurality of sections having respective heights corresponding to different heights of a plurality of components, at least one section having a separate deforming means for respectively contacting said plurality of components.

10. The apparatus of any preceding claim, further comprising means for sealing a container, the sealing means comprising a lid-like member integrally formed with the thermal energy transferring means of the apparatus, which lid-like member is configured to close a chamber for containing one or more components.

11. The apparatus of any of claims 1 to 9, further comprising means for containing a fluid, the containing means being integrally formed with, and containing at least part of, the thermal energy transferring means, and the deforming means being at least partly external to the containing means.

12. The apparatus of claim 11, wherein the containing means further comprises a first aperture for receiving a liquid and a second aperture for the liquid to exit in use.

13. A method of manufacture of an apparatus of any preceding claim, the method comprising integrally forming the thermal energy transferring means and the deforming means by additive or subtractive manufacturing using a common material.

14. The method of claim 13, wherein the thermal energy transferring means is formed as a three-dimensional lattice structure comprising a substantially repeating arrangement of struts and nodes arranged in such a way as to resist deformation due to applied pressure.

15. The method of claim 13 or claim 14, wherein the deforming means is formed by a plurality of struts that each extend generally away, and at an oblique angle from, a node of the thermal energy transferring means and which undergo rotational movement due to applied pressure when contacting the component.
